# EUROPÄISCHE PATENTSCHRIFT

(11) **EP 0 992 801 B1**
(45) Veröffentlichungstag und Bekanntmachung des Hinweises auf die Patenterteilung: **12.09.2007**
(21) Anmeldenummer: 99119052.1
(22) Anmeldetag: 29.09.1999
(51) Int. Cl.: G01R 31/00

(54) **Verfahren und Vorrichtung zur Ermittlung des Bordnetzzustands eines Kraftfahrzeugs**
Method and apparatus for determining the state of an on-board network in a motor vehicle
Procédé et appareil pour déterminer l'état d'un réseau de bord dans un vehicule automobile

(30) Priorität: 02.10.1998 DE 19845565; 02.10.1998 DE 19845562
(43) Veröffentlichungstag der Anmeldung: 12.04.2000
(73) Patentinhaber: Volkswagen Aktiengesellschaft, 38436 Wolfsburg (DE)
(72) Erfinder: Dierker, Uwe, Dipl.-Ing., 38550 Isenbüttel (DE); Michels, Karsten, Dr., 38126 Braunschweig (DE)
(74) Vertreter: Zucker, Volker

(56) Entgegenhaltungen:
- DE-A- 3 145 732
- US-A- 4 207 611
- PATENT ABSTRACTS OF JAPAN vol. 008, no. 275 (P-321), 15. Dezember 1984 (1984-12-15) & JP 59 142483 A (NISSAN JIDOSHA KK), 15. August 1984 (1984-08-15)

## Beschreibung

Die Erfindung betrifft ein Verfahren zur Ermittlung des Bordnetzzustands eines Kraftfahrzeugs gemäß Oberbegriff des Anspruchs 1 sowie eine Vorrichtung zur Durchführung des Verfahrens.

Der Bordnetzzustand eines Kraftfahrzeugs kann durch Messung der Batteriespannung ermittelt werden, wobei eine unterhalb eines kritischen Spannungswerts befindliche Batteriespannung eine kritische Bordnetzsituation kennzeichnen kann. Ob es sich dabei um eine vorübergehende kritische Bordnetzsituation oder um einen wirklich ernsthaften kritischen Bordnetzzustand handelt, kann unter Berücksichtigung der Ladebilanz der Fahrzeugbatterie festgestellt werden. Zu diesem Zweck können beispielsweise die Spannungswerte der Batteriespannung über einen längeren Zeitraum betrachtet werden.

Eine richtige Einschätzung des Bordnetzzustands sollte mit größter Sorgfalt erfolgen, da eine Fehleinschätzung entweder das Liegenbleiben eines Fahrzeugs oder das unnötige Abschalten von Verbrauchern zur Folge haben kann. Aus diesem Grunde sollten bei der Beurteilung des Bordnetzzustands nur diese Ereignisse berücksichtigt werden, die einen relevanten Einfluß auf den Bordnetzzustand haben.

Aus der DE 195 46 553 C1 ist ein Verfahren zum Prüfen von elektrischen Verbrauchern in einem Bordnetz eines Kraftfahrzeugs bekannt. Für jeden von der Fahrzeugbatterie gespeisten Verbraucher wird die Batteriespannung unmittelbar vor und kurz nach dem Ausschalten eines zuvor eingeschalteten Verbrauchers gemessen und aus der verbraucherspezifischen Batteriespannungsdifferenz der verbraucherspezifische Stromaufnahmewert ermittelt. Mit diesem Verfahren kann eine einfache Überprüfung der Elektrik im Fahrzeug vorgenommen werden. Eine Beurteilung des Bordnetzzustands ist jedoch bei diesem bekannten Verfahren nicht vorgesehen.

Eine Auswertung der Spannungsverläufe, die durch das Ein- bzw. Ausschalten von Verbrauchern entstehen, zur Funktionsüberprüfung elektrischer Verbraucher, ist auch aus der DE 44 34 616 A1 bekannt, wobei insbesondere mit diesem Verfahren eine Unfalldatenerfassung in der Weise erfolgen soll, daß beispielsweise nachgewiesen werden kann, ob ein Bremslicht eingeschaltet oder ein Blinker betätigt worden ist. Ein ähnlicher Tester ist aus der US - 4,207,611 A bekannt.

Der Erfindung liegt die Aufgabe zugrunde, ein Verfahren und eine Vorrichtung zur Ermittlung des Bordnetzzustands eines Kraftfahrzeugs zu schaffen, die eine verbesserte Bordnetzzustandserkennung ermöglichen. Diese Aufgabe wird durch die Merkmale der Ansprüche 1 und 5 gelöst. Vorteilhafte Weiterbildungen der Erfindung sind in den Unteransprüchen angegeben.

In Abhängigkeit von der aktuellen Bordnetzsituation wird entweder ein über einen längeren Zeitraum gemittelter Spannungswert oder ein aktueller Spannungswert, aus dem kurzzeitige Spannungsänderungen herausgefiltert sind, als Batteriespannung ausgewertet. In einer Bordnetzsituation, in der keine kurzzeitigen Hochstromverbraucher eingeschaltet sind, wird der gefilterte aktuelle Spannungswert als Batteriespannung ausgewertet.

Dabei wird der aktuelle Spannungswert zur Beurteilung des Bordnetzzustands nur dann herangezogen wird, wenn kein kurzzeitiger Hochstromverbraucher eingeschaltet ist und/oder wenn bei eingeschaltetem kurzzeitigen Hochstromverbraucher der aktuelle Spannungswert größer ist als der über einen längeren Zeitraum gemittelte Spannungswert. Dadurch wird sichergestellt, daß stets die tatsächlich relevanten Spannungseinbrüche zur Beurteilung des Bordnetzzustands herangezogen werden. Der dabei in die Auswertung mit einbezogene aktuelle Spannungswert wird nicht durch irrelevante kurzfristige Spannungseinbrüche verfälscht, die z. B. durch das Einschalten induktiver Lasten und die Regelfunktionen des Generators auftreten können.

Außerdem wird durch die zeitliche Mittelung über einen längeren Zeitraum, beispielsweise über einen Zeitraum von zwei Minuten, der Einfluß der kurzzeitigen Hochstromverbraucher auf den gemittelten Spannungswert stark reduziert, so daß die dadurch hervorgerufenen Spannungseinbrüche im Bordnetz nur einen reduzierten Einfluß auf den zur Beurteilung des Bordnetzzustands herangezogenen Spannungswert haben. Würde man diese zeitliche Mittelung nicht vornehmen, hätte dies zur Folge, daß die durch kurzzeitige Hochstromverbraucher hervorgerufenen Spannungseinbrüche überbewertet werden würden.

Ein Verbraucher kann dann als kurzzeitiger Hochstromverbraucher eingestuft werden, wenn die zu erwartende Einschaltzeit kleiner als 30 Sekunden bei einem Strom von mehr als 10 A beträgt. Derartige Verbraucher sind z. B. der Motor der Servolenkung, Fensterhebermotoren und der Motor der Scheibenwaschanlage.

Die zum Filtern kurzzeitiger Spannungsänderungen vorgesehene Zeitkonstante kann so gewählt sein, daß Spannungseinbrüche mit einer Dauer von weniger als eine Sekunde aus dem Spannungswert herausgefiltert werden. Dadurch wird sichergestellt, daß die im Millisekundenbereich liegenden induktiven Spannungsschwankungen zur Beurteilung des Bordnetzzustands nicht fälschlicherweise mit in Betracht gezogen werden.

Eine Auswerteeinrichtung ist mit dem Datenbus des Bordnetz-Steuerungsnetzwerks (CAN-Bus) verbunden, der das Ein- und Ausschalten von kurzzeitigen Hochstromverbrauchern anzeigen kann. Außerdem liegt an der Auswerteeinrichtung die gefilterte Batteriespannung und ein zeitlich gemittelter Spannungswert an, so daß die Auswerteeinrichtung am Ausgang den jeweils zur Beurteilung des Bordnetzzustands relevanten, aufbereiteten Batteriespannungsmeßwert an eine Batteriespannungüberwachungseinrichtung abgeben kann. Die Batteriespannungsüberwachungseinrichtung kann durch Vergleich mit kritischen Spannungsschwellwerten oder durch Betrachtung der anliegenden Batteriespannung über einen längeren Zeitraum entscheiden, ob ein kritischer Bordnetzzustand vorliegt. Wie lange und in welchem Maße eine Unterschreitung von vorgegebenen kritischen Batteriespannungswerten als kritischer Bordnetzzustand betrachtet wird, kann beispielsweise von der Batteriekapazität oder von anderen individuellen fahrzeugspezifischen Kriterien abhängig sein. Wesentlich ist dabei in jedem Falle, daß für die Beurteilung des Bordnetzzustands ein erfindungsgemäß durch Filtern und/oder durch zeitliche Mittelung aufbereiteter Spannungswert verwendet wird.

Die Erfindung wird nachfolgend anhand eines in der Zeichnung dargestellten Ausführungsbeispiels näher erläutert.

Es zeigen:
- Figur 1: ein Flußdiagramm des Verfahrens zur Ermittlung des Bordnetzzustands, bei dem eine aufbereitete Batteriespannung zur Auswertung bereitgestellt wird und
- Figur 2: ein vereinfachtes Blockschaltbild einer Vorrichtung zur Durchführung des erfindungsgemäßen Verfahrens.

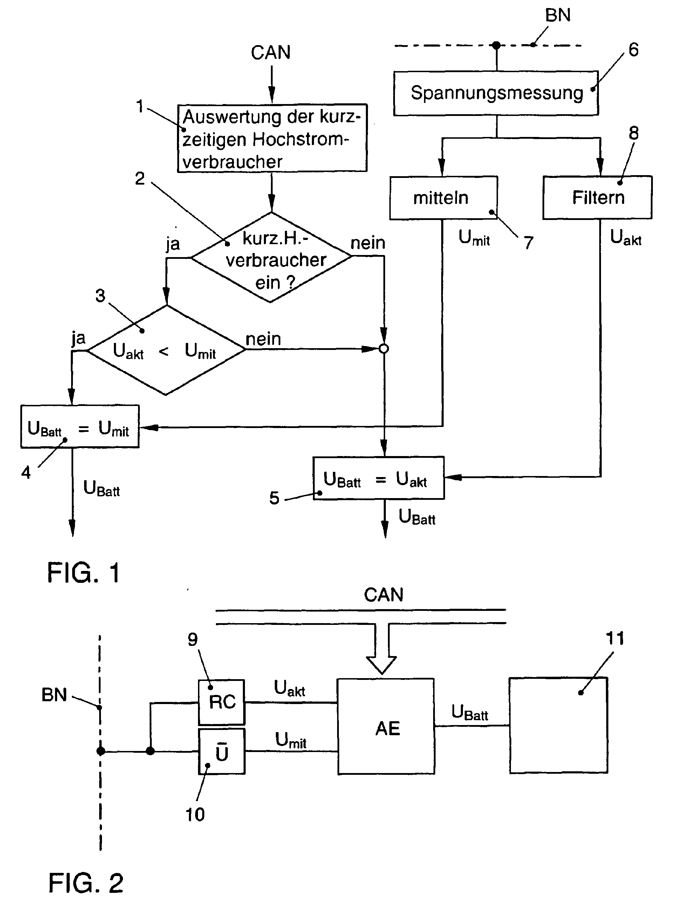

Das in Figur 1 dargestellte Flußdiagramm gibt die Maßnahmen an, die zur Bereitstellung einer zur Ermittlung des Bordnetzzustands geeigneten Batteriespannung U_{Batt} angewendet werden. Dabei wird berücksichtigt, daß die zur Beurteilung des Bordnetzzustands verwendete Batteriespannung U_{Batt} von zustandsirrelevanten Spannungseinbrüchen befreit sein soll.

Von dem zu Steuerungszwecken im Kraftfahrzeug vorhandenen CAN-Bus wird zunächst ein Datensignal entsprechend dem Funktionsblock 1 entnommen, welches eine Kennzeichnung darüber enthält, ob ein kurzzeitiger Hochstromverbraucher eingeschaltet ist, oder nicht. Die Auswertung des Datensignals erfolgt in einem Funktionsblock 2, der im Falle eines eingeschalteten kurzzeitigen Hochstromverbrauchers (ja) zu einem Funktionsblock 3 überleitet, bei dem geprüft wird, ob der am Bordnetz gemessene aktuelle Spannungswert Uₐₖₜ kleiner ist als ein zeitlich gemittelter Spannungswert Uₘᵢₜ der Bordnetzspannung. Ist Uₐₖₜ kleiner Uₘᵢₜ wird gemäß Funktionsblock 4 die zur Weiterverarbeitung vorgesehene Batteriespannung U_{Batt} dem gemittelten Spannungswert Uₘᵢₜ gleichgesetzt.

Wird aus dem vom CAN-Bus abgeleiteten Datensignal im Funktionsblock 2 entnommen, daß kein kurzzeitiger Hochstromverbraucher eingeschaltet ist (nein), so wird die zur weiteren Berücksichtigung verwendete Batteriespannung U_{Batt} auf den aktuellen Spannungswert Uₐₖₜ gemäß Funktionsblock 5 gesetzt. Die Zuordnung wird auch in dem Fall getroffen, wenn bei einem eingeschalteten kurzzeitigen Hochstromverbraucher gemäß Funktionsblock 3 festgestellt wird, daß der aktuelle Spannungswert Uₐₖₜ nicht kleiner ist als der gemittelte Spannungswert Uₘᵢₜ.

Die Bereitstellung der Spannungswerte Uₘᵢₜ und Uₐₖₜ wird anhand der Funktionsblöcke 6 bis 8 veranschaulicht. Die im Bordnetz BN auftretende Spannung wird gemäß Funktionsblock 6 gemessen und einer zeitlichen Mittelung unterzogen, die vom Funktionsblock 7 repräsentiert wird. Außerdem wird die gemessene Spannung entsprechend dem Funktionsblock 8 derart gefiltert, daß kurzzeitige Spannungseinbrüche, die im Millisekundenbereich liegen, eliminiert werden. Man erhält somit ausgangsseitig des Funktionsblocks 8 den gefilterten Spannungswert Uₐₖₜ.

Anhand des in Figur 2 dargestellten Blockschaltbilds wird der grundsätzliche Aufbau einer Vorrichtung zur Durchführung des erfindungsgemäßen Verfahrens dargestellt.

Aus dem Bordnetz BN wird über ein RC-Filter 9 mit kleiner Zeitkonstante der gefilterte Spannungswert Uₐₖₜ gewonnen, der einem Eingang einer Auswerteeinrichtung AE zugeführt wird. Außerdem wird die Spannung des Bordnetzes BN einem Spannungsmittler 10 zugeführt, der Ausgangsseitig den zeitlich gemittelten Spannungswert Uₘᵢₜ einem zweiten Eingang der Auswerteeinrichtung AE zuführt. Über den CAN-Bus erhält die Auswerteeinrichtung AE außerdem ein Datensignal, welches anzeigt, ob ein kurzzeitiger Hochstromverbraucher eingeschaltet ist. Die Auswerteeinrichtung AE kann aufgrund der an ihr anliegenden Signale eine Spannungszuordnung gemäß dem in Figur 1 dargestellten Flußdiagramm vornehmen und ausgangsseitig die Batteriespannung U_{Batt} an eine Batteriespannungsüberwachungseinrichtung 11 übermitteln, die beispielsweise prüft, ob die Batteriespannung U_{Batt} über einen vorgegebenen Zeitraum einen kritischen Spannungswert unterschreitet und ob somit ein kritischer Bordnetzzustand vorliegt. In welcher Weise die Batteriespannungsüberwachungseinrichtung 11 die aufbereitete Batteriespannung U_{Batt} zur Erkennung eines kritischen Bordnetzzustands weiterverarbeitet ist an sich nicht Gegenstand der vorliegenden Erfindung. Die hierfür vorgesehenen Entscheidungskriterien können sehr unterschiedlich und insbesondere abhängig von den jeweiligen individuellen Anforderungen sein. In jedem Fall ist es aber sehr wichtig, daß die zur Beurteilung des Bordnetzzustands herangezogene Batteriespannung U_{Batt} von zustandsirrelevanten Spannungseinbrüchen bereinigt ist, was durch die erfindungsgemäße Aufbereitung der Batteriespannung U_{Batt} gewährleistet wird.

### BEZUGSZEICHENLISTE

- 1: Funktionsblock
- 2: Funktionsblock
- 3: Funktionsblock
- 4: Funktionsblock
- 5: Funktionsblock
- 6: Funktionsblock
- 7: Funktionsblock
- 8: Funktionsblock
- 9: RC-Filter
- 10: Spannungsmittler
- 11: Bordnetzüberwachungseinrichtung
- U_{Batt}: Batteriespannung
- Uₘᵢₜ: Spannungswert
- Uₐₖₜ: Spannungswert
- AE: Auswerteeinrichtung
- BN: Bordnetz

## Patentansprüche

1. Verfahren zur Ermittlung des Bordnetzzustands eines Kraftfahrzeugs, bei dem zur Beurteilung des Bordnetzzustands geprüft wird, ob die im Bordnetz (BN) vorhandene Spannung der Fahrzeugbatterie einen kritischen Grenzwert erreicht, der einen kritischen Bordnetzzustand repräsentiert, **dadurch gekennzeichnet, daß** je nach Bordnetzsituation ein über einen längeren Zeitraum gemittelter Spannungswert (Uₘᵢₜ) oder ein aktueller Spannungswert (Uₐₖₜ), aus dem kurzzeitige Spannungsänderungen herausgefiltert sind, als Batteriespannung (U_{Batt}) ausgewertet wird, wobei der aktuelle Spannungswert (Uₐₖₜ) zur Beurteilung des Bordnetzzustands nur dann herangezogen wird, wenn kein kurzzeitiger Hochstromverbraucher eingeschaltet ist und/oder wenn bei eingeschaltetem kurzzeitigen Hochstromverbraucher der aktuelle Spannungswert (Uₐₖₜ) größer ist als der über einen längeren Zeitraum gemittelte Spannungswert (Uₘᵢₜ).

2. Verfahren Anspruch 1, **dadurch gekennzeichnet, daß** der Zeitraum zur Mittelung für den gemittelten Spannungswert (Uₘᵢₜ) im Minutenbereich liegt.

3. Verfahren nach einem der vorhergehenden Ansprüche, **dadurch gekennzeichnet, daß** ein Verbraucher als kurzzeitiger Hochstromverbraucher eingestuft wird, wenn die zu erwartende Einschaltzeit im Sekundenbereich liegt.

4. Verfahren nach einem der vorhergehenden Ansprüche, **dadurch gekennzeichnet, daß** die Zeitkonstante zum Filtern kurzzeitiger Spannungsänderungen so gewählt ist, daß Spannungseinbrüche beim Einschalten induktiver Lasten sowie die Antwortfunktion des Generators herausgefiltert werden.

5. Vorrichtung zur Durchführung des Verfahrens nach einem der vorhergehenden Ansprüche, die Einrichtungen zur Beurteilung des Bordnetzzustands anhand von am Bordnetz (BN) gemessenen Spannungswerten hat, **dadurch gekennzeichnet, daß** eine Auswerteeinrichtung (AE) mit einem Datenbus, über ein Filter (9) mit kleiner Zeitkonstante mit dem Bordnetz (BN) und mit dem Ausgang eines Spannungsmittlers (10) an dem eingangsseitig die Bordnetzspannung anliegt, verbunden ist, wobei die Auswerteeinrichtung (AE) über den Datenbus ein Datensignal erhält, das eingeschaltete kurzzeitige Hochstromverbraucher kennzeichnet, und daß die Auswerteeinrichtung (AE) am Ausgang die zur Beurteilung des Bordnetzzustands geeignete Batteriespannung (U_{Batt}) mit dem aktuellen Spannungswert (Uₐₖₜ) oder dem gemittelten Spannungswert (Uₘᵢₜ) an eine Batteriespannungsüberwachungseinrichtung (11) überträgt.

## Claims

1. Method for determining the state of an on-board power system in a motor vehicle, in which, in order to assess the state of the on-board power system it is checked whether the vehicle battery voltage which is present on the on-board power system (BN) reaches a critical limiting value which represents a critical state of an on-board power system, **characterized in that** depending on the situation of the on-board power system a voltage value (Uₘᵢₜ) which is averaged over a relatively long period of time or a current voltage value (Uₐₖₜ) from which brief changes in voltage are filtered out is evaluated as a battery voltage (U_{Batt}), wherein the current voltage value (Uₐₖₜ) is used to assess the state of the on-board power system only if no brief high-current load is switched on and/or if the current voltage value (Uₐₖₜ) when a brief high-current load is switched on is higher than the voltage value (Uₘᵢₜ) which is averaged over a relatively long period of time.

2. Method according to Claim 1, **characterized in that** the period of time for the averaging for the averaged voltage value (Uₘᵢₜ) is in the minute range.

3. Method according to one of the preceding claims, **characterized in that** a load is classified as a brief high-current load if the anticipated switch-on time lies in the seconds range.

4. Method according to one of the preceding claims, **characterized in that** the time constant for filtering brief changes in voltage is selected such that voltage dips when inductive loads are switched on and the response function of the generator are filtered out.

5. Device for carrying out the method according to one of the preceding claims, which device has apparatuses for assessing the state of the on-board power system by reference to voltage values which have been measured at the on-board power system (BN), **characterized in that** an evaluation device (AE) is connected to a data bus, to the on-board power system (BN) via a filter (9) with a small time constant, and to the output of a voltage averaging means (10) to whose input side the on-board power system voltage is applied, wherein the evaluation device (AE) receives, via the data bus, a data signal which characterizes briefly switched-on high-current loads, and **in that** the evaluation device (AE) transmits, at the output, the battery voltage (U_{Batt}) which is suitable for assessing the state of the on-board power system and which has the current voltage value (Uₐₖₜ) or the averaged voltage value (Uₘᵢₜ) to a battery voltage monitoring device (11).

## Revendications

1. Procédé pour déterminer l'état du réseau de bord d'un véhicule automobile avec lequel pour évaluer l'état du réseau de bord, on contrôle si la tension de la batterie du véhicule présente dans le réseau de bord (BN) atteint une valeur limite critique qui représente un état critique du réseau de bord, **caractérisé en ce** suivant la situation du réseau de bord, une valeur de tension moyennisée sur une longue période (Uₘᵢₜ) ou une valeur actuelle de la tension (Uₐₖₜ) dont sont éliminées par filtrage les variations de tension de courte durée est interprétée comme étant la tension de batterie (U_{Batt}), la valeur actuelle de la tension (Uₐₖₜ) n'étant utilisée pour évaluer l'état du réseau de bord que lorsqu'aucune charge à courant fort de courte durée n'est mise en circuit et/ou, lorsqu'une charge à courant fort de courte durée est mise en circuit et la valeur actuelle de la tension (Uₐₖₜ) est supérieure à la valeur de tension moyennisée sur une longue période (Uₘᵢₜ).

2. Procédé selon la revendication 1, **caractérisé en ce que** la période de détermination de la valeur de tension moyennisée (Uₘᵢₜ) est de l'ordre de quelques minutes.

3. Procédé selon l'une des revendications précédentes, **caractérisé en ce qu'**une charge à courant fort est considérée de courte durée lorsque la durée de mise en circuit prévue est de l'ordre de quelques secondes.

4. Procédé selon l'une des revendications précédentes, **caractérisé en ce que** la constante de temps pour filtrer les variations de tension de courte durée est choisie de telle sorte que les chutes de tension lors de la mise en circuit de charges inductives ainsi que la fonction de réaction de l'alternateur sont éliminées par filtrage.

5. Dispositif pour mettre en oeuvre le procédé selon l'une des revendications précédentes, lequel comprend des dispositifs pour évaluer l'état du réseau de bord au moyen de valeurs de tension mesurées sur le réseau de bord (BN), **caractérisé en ce qu'**un dispositif d'évaluation (AE) comprenant un bus de données est relié par le biais d'un filtre (9) à faible constante de temps avec le réseau de bord (BN) et avec la sortie d'un calculateur de moyenne de tension (10) à l'entrée duquel est appliquée la tension du réseau de bord, le dispositif d'évaluation (AE) recevant par le biais du bus de données un signal de données qui identifie la charge à courant fort de courte durée qui est mise en circuit et **en ce que** le dispositif d'évaluation (AE) transmet à la sortie la tension de batterie (U_{Batt}) appropriée pour évaluer l'état du réseau de bord avec la valeur actuelle de la tension (Uₐₖₜ) ou la valeur moyennisée de la tension (Uₘᵢₜ) à un dispositif de surveillance de la tension de batterie (11).
